# DEMANDE DE BREVET EUROPEEN

(11) **EP 3 836 213 A1**
(43) Date de publication de la demande: **16.06.2021**
(21) Numéro de dépôt: 20213962.2
(22) Date de dépôt: 14.12.2020
(51) Int. Cl.: H01L 25/075, H01L 25/16

(54) **SOURCE LUMINEUSE A ELEMENTS SEMICONDUCTEURS ELECTROLUMINESCENTS**

(30) Priorité: 12.12.2019 FR 1914320
(71) Demandeur: Valeo Vision, 93012 Bobigny Cedex (FR)
(72) Inventeur: ZOJCESKI, Zdravko, 93012 Bobigny - Cedex (FR); DAROUSSIN, Samuel, 93012 Bobigny - Cedex (FR); DE LAMBERTERIE, Antoine, 93012 Bobigny - Cedex (FR); VAL, Alexandre, 93012 Bobigny - Cedex (FR); CANONNE, Thomas, 93012 Bobigny - Cedex (FR)
(74) Mandataire: Valeo Visibility

(57) **Abrégé**

L'invention propose une source lumineuse à plusieurs composants semi-conducteurs électroluminescents. La source lumineuse proposée permet notamment de l'utiliser pour assembler des sources matricielles à matrice active ayant des pixels de type micro-LED, sans pour autant nécessiter une matrice dédiée de transistors.

## Description

L'invention se rapporte aux sources lumineuses à éléments semi-conducteurs électroluminescents. En particulier, l'invention se rapporte à une telle source lumineuse adaptée à réaliser un pixel lumineux d'une matrice pixellisée, notamment pour un véhicule automobile.

Une diode électroluminescente, LED, est un composant électronique semi-conducteur capable d'émettre de la lumière lorsqu'il est parcouru par un courant électrique ayant au moins une intensité seuil. Dans le domaine automobile, on a de plus en plus recours à la technologie LED pour diverses solutions de signalisation lumineuse. La possibilité de réaliser des composants électroniques semi-conducteurs électroluminescents de dimensions de plus en plus réduites offre la possibilité d'en constituer des dispositifs d'affichages, qui peuvent être utilisés dans le domaine automobile comme dispositifs lumineux ou systèmes d'information, mais également dans d'autres domaines ou un affichage digital lumineux est requis.

Il est connu de piloter une matrice de LEDs selon le principe de matrice active. Selon ce principe, chaque LED d'une matrice peut être activée en commutant un circuit interrupteur associé à la LED. Les circuits interrupteurs sont de manière connue réalisés par une matrice de transistors à couche fine, TFT, (« thin film transistor »), créant ainsi un panneau de transistors auquel les LEDs de la matrice de LEDs sont connectés.

Les coûts de production d'une matrice de transistors à couche fine, dont la disposition dépend de la disposition des LEDs dans la matrice de LEDs correspondante sont très élevés, ce qui rend la technologie peu flexible. Notamment dans le domaine automobile, des écrans d'affichage externes peuvent varier d'un modèle de véhicule à l'autre. Le développement de panneaux de type TFT correspondants serait prohibitif en termes de coûts. Par ailleurs, la fiabilité de l'affichage ne dépendrait pas seulement de la fiabilité des LEDs, mais encore de la fiabilité de transistors couche mince.

L'invention a pour objectif de pallier à au moins un des problèmes posés par l'art antérieur. En particulier l'invention a pour objectif de proposer une source lumineuse de taille réduite, pouvant être utilisée comme pixel dans une source lumineuse ou en un dispositif d'affichage pixélisé, qui soit réalisable à coût raisonnable et qui satisfasse aux critères de fiabilité requis par l'industrie automobile.

Selon un premier aspect de l'invention, une source lumineuse est proposée. La source lumineuse est destinée à réaliser au moins un pixel lumineux d'une matrice active de sources lumineuses. La source lumineuse comprend un boîtier ayant une première face et une deuxième face y opposée, le boîtier comprenant au moins deux composants semi-conducteurs électroluminescents agencés de manière à pouvoir émettre de la lumière par ladite première face, un circuit électronique, et des contacts électriquement conducteurs agencés sur la deuxième face et reliés aux composants semi-conducteurs et/ou au circuit électronique. La source lumineuse est remarquable en ce que le circuit électronique comprend un montage interrupteur adapté à alimenter sélectivement au moins un des composants semi-conducteurs électroluminescents.

De préférence, le boîtier peut être de forme parallélépipédique. Les composants peuvent de préférence être maintenus dans le boîtier par une résine, notamment une résine époxy. De préférence, la plus grande face du boîtier peut être carrée et peut avoir une longueur d'arête de 100 micromètres ou de 250 micromètres. Alternativement, la longueur d'arête peut être de 500 micromètres. Elle peut notamment être comprise entre 300 et 500 micromètres.

De préférence, le montage interrupteur peut comprendre au moins un transistor à effet de champ de type MOSFET, et une capacité. Le circuit électronique peut préférentiellement être réalisé par un circuit intégré. De préférence, la source comprend au moins un transistor par composant semi-conducteur électroluminescent, le transistor étant fonctionnellement relié audit composant.

Les composants semi-conducteurs électroluminescents peuvent de préférence comprendre des diodes électroluminescentes, LED. La distance entre deux composants semi-conducteurs électroluminescents peut de préférence être inférieure ou égale à 250 micromètres. De préférence, cette distance peut se situer entre 30 micromètres et 250 micromètres.

De préférence, la face émettrice des composants semi-conducteurs peut présenter une longueur et/ou largeur comprise entre 30 et 70 micromètres.

La source lumineuse peut préférentiellement être destinée à réaliser un pixel lumineux d'une matrice active de sources lumineuses, et elle peut comprendre trois composants semi-conducteurs électroluminescents.

Chaque composant semi-conducteur électroluminescent peut de préférence être destiné à émettre de la lumière de couleur différente. Les composants semi-conducteurs électroluminescents peuvent comprendre au moins une diode électroluminescente émettant de la lumière rouge, blanche, ou ambre.

De préférence, la première face du boîtier peut être au moins partiellement revêtue d'une couche mince de protection. La couche mince de protection peut de préférence couvrir au moins les faces émettrices des composants semi-conducteurs électroluminescents.

La couche mince de protection peut comprendre au moins une couche inorganique comprenant du Silicium. La couche inorganique peut de préférence comprendre de l'oxyde de Silicium ou de l'oxynitrure de Silicium. La couche inorganique peut de préférence être transparente à la lumière visible.

De manière préférée, la première face du boîtier peut être au moins partiellement revêtue d'une couche de vernis. De préférence, la couche de vernis ne couvre les faces émettrices de composants semi-conducteurs électroluminescents. De préférence, la couche de vernis peut recouvrir au moins partiellement la couche mince de protection.

La couche de vernis peut de préférence comprendre une couche de passivation organique, préférentiellement de couleur noire.

Selon un autre aspect de l'invention, un dispositif lumineux pixélisé à matrice active comprenant une pluralité de pixels lumineux est proposé. Le dispositif est remarquable en ce que les pixels sont réalisés par des sources lumineuses conformes à un aspect précédent de l'invention. Les sources lumineuses qui réalisent les pixels sont fonctionnellement reliées, et les interrupteurs de sélection de la matrice active sont réalisés par les circuits électroniques respectifs des sources lumineuses. De préférence, le dispositif lumineux peut comprendre au moins mille sources lumineuses agencées de manière matricielle.

Selon un autre aspect de l'invention, un module lumineux pour un véhicule automobile est proposé. Le module lumineux est remarquable en ce qu'il comprend au moins un dispositif lumineux conforme à la revendication précédente.

Selon encore un autre aspect de l'invention, un procédé de fabrication d'une source lumineuse est proposé. Le procédé est remarquable en ce qu'il comprend les étapes suivantes :
- placement, sur une surface de support, d'au moins deux composants semi-conducteurs électroluminescents et d'un circuit intégré réalisant un circuit d'interrupteur adapté à alimenter sélectivement au moins un des composants semi-conducteurs électroluminescents, les faces émettrices des éléments semi-conducteurs électroluminescents étant tournées vers le bas ;
- réalisation d'une encapsulation wafer (connue de l'homme de la technique sous l'appellation anglo-saxonne « wafer level packaging »), comprenant une étape de moulage d'une résine autour desdits composants ;
- après la séparation de ladite encapsulation de ladite surface de support, application d'une mince couche de protection comprenant du Silicium sur au moins les faces émettrices des éléments semi-conducteurs.

On comprend que, lorsque la source lumineuse est fabriquée selon ce procédé, la face du circuit intégré placée sur la surface de support est au même niveau que les faces émettrices des éléments semi-conducteurs électroluminescents, de sorte que les faces émettrices des éléments semi-conducteurs électroluminescents sont situées sur un plan d'émission de la source lumineuse ne comportant pas de protubérance, ce qui permet de garantir l'homogénéité du flux émis par la source lumineuse.

De préférence, avant la réalisation de l'encapsulation, le procédé peut comprendre une étape de dépôt d'au moins une couche minérale (inorganique) pour protéger au plus près les bords des composants LED et IC présents. Ce dépôt ne couvre de préférence pas les faces actives des LEDs, alors qu'il couvre les faces actives ou exposées du circuit intégré en Si.

De préférence, le procédé peut en outre comprendre une étape d'application d'un vernis sur au moins les faces émettrices des éléments semi-conducteurs. De préférence, l'étape d'application d'un vernis peut être réalisé après la réalisation d'une mince couche de protection.

En utilisant les aspects selon l'invention, il devient possible de réaliser une source lumineuse incorporant une pluralité de composants semi-conducteurs électroluminescent, notamment de type micro-LED, ainsi qu'un circuit électronique qui permet de l'intégrer facilement au sein d'une matrice active comprenant une pluralité de telles sources lumineuses. Comme la source lumineuse proposée utilise des composants produits indépendamment les uns des autres, le fonctionnement de ceux-ci peut être testé au préalable, et d'éventuels défauts peuvent être détectés avant leur assemblage au dans un boîtier commun. Ceci est notamment le cas pour les éléments semi-conducteurs électroluminescents de type LED, dont par exemple les valeurs de BIN peuvent être testés au préalable, ainsi que d'autres caractéristiques électriques qui leurs sont propres. L'agencement proposé peut être réalisé par des méthodes de type sélection et placement (connues de l'homme de la technique sous l'appellation anglo-saxonne « pick-and-place ») ou transfert de masse (connues de l'homme de la technique sous l'appellation anglo-saxonne « mass transfer»), qui permettent de placer les composants requis (LEDs, circuits intégrés) rapidement et précisément sur un support de travail lors de la fabrication. Les composants sont protégés lors de l'assemblage de la source lumineuse puisque leurs faces actives sont en contact avec un support, alors qu'un surmoulage de résine est réalisé sur leurs faces libres. Selon des aspects de l'invention, au moins une couche de protection peut être prévue sur cette face active après l'assemblage, de manière à rendre la source lumineuse apte à résister aux conditions atmosphériques contraignantes auxquelles elle peut être exposée dans un véhicule automobile (variations de température, hygrométrie, etc....). Afin d'éviter des effets optiques indésirables, une couche de vernis appropriée peut de préférence être appliquée. Selon la taille boîtier qui regroupe les composants semi-conducteurs électroluminescents ensemble avec le circuit électronique, la source lumineuse selon l'invention peut de préférence être réalisée selon un procédé de WLP (« wafer level packaging »).

D'autres caractéristiques et avantages de la présente invention seront mieux compris à l'aide de la description des exemples et des dessins parmi lesquels :
la Fig. 1 est une illustration schématique d'une vue d'en haut sur une source lumineuse selon un mode de réalisation préférentiel de l'invention ;
la Fig. 2 est une illustration schématique d'une vue d'en bas sur une source lumineuse selon un mode de réalisation préférentiel de l'invention ;
la Fig. 3 est une illustration schématique d'une vue latérale sur une coupe transversale d'une source lumineuse selon un mode de réalisation préférentiel de l'invention ;
la Fig. 4 est une illustration schématique d'une source lumineuse matricielle selon un mode de réalisation préférentiel de l'invention ;
la Fig. 5 est une illustration d'un schéma de montage d'une source matricielle selon un mode de réalisation préférentiel de l'invention.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre d'exemples et de manière non limitative. Des numéros de référence similaires seront utilisés pour décrire des concepts semblables à travers différents modes de réalisation de l'invention. Par exemple, les références 100 et 200 désignent deux modes de réalisation d'une source lumineuse selon l'invention.

La description se concentre sur les caractéristiques qui démarquent la source lumineuse proposées de l'état de l'art. Le fonctionnement et la fabrication de composants de type micro-LED ne sera pas décrit en détail puisqu'il est en soi connu dans l'art. Il en est de même pour la fabrication et le fonctionnement de transistors, et par exemple l'alimentation électrique d'une source lumineuse comme celle qui sera proposée. Par exemple, dans le cas d'une application au sein d'un véhicule automobile, un courant électrique de charge est généralement fourni par un dispositif de pilotage de l'alimentation électrique de la source, impliquant généralement un circuit convertisseur adapté à convertir un courant d'entrée fourni par une source internet au véhicule automobile, telle qu'une batterie, en un courant de charge d'intensité adaptée à l'alimentation de la source lumineuse. De même, l'intensité lumineuse et l'adressage sélectif de pixels d'une matrice active peuvent être réalisés moyennant des signaux de commande adaptés, en soi connus dans l'art.

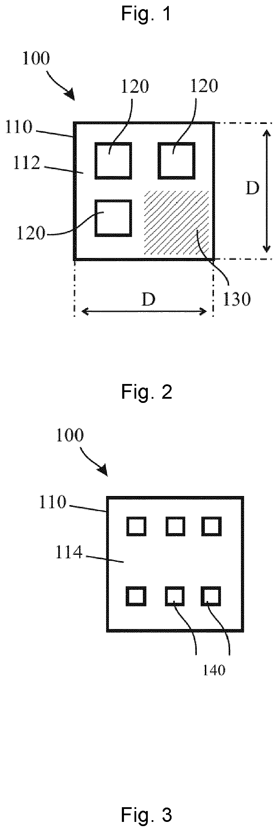

La Fig. 1 montre de manière schématique une source lumineuse 100 selon un premier mode de réalisation conforme à l'invention. Une vue d'en haut sur une première face 112 du boîtier 110 de la source lumineuse 110 est montrée. On y aperçoit trois composants semi-conducteurs électroluminescents, préférablement de type micro-LED, 120. Les composants semi-conducteurs peuvent comprendre une couche de conversion optique sur leur face émettrice sans pour autant sortir du cadre de la présente invention. Un composant micro-LED se caractérise par une face émettrice ayant une étendue d'environ 30 à 70 micromètres. Evidemment le nombre de diodes électroluminescentes n'est pas limité à trois et chaque pluralité de tels composants est couverte par la présente invention. L'agencement des LEDs 120 est tel qu'elles sont aptes à émettre de la lumière à travers la première face 112 du boîtier. Dans l'exemple montré, la première face 112 est carrée et a une longueur d'arête D d'environ 250 micromètres. Les LEDs 120 peuvent être de des LEDs semblables, émettant le même couleur de lumière, ou bien des composants capables d'émettre des couleurs de lumière différentes, notamment rouge, bleue et verte. La source lumineuse comprend en outre un circuit électronique 130, qui est par exemple réalisé par un circuit intégré. Le circuit électronique comprend un montage interrupteur qui est fonctionnellement adapté à alimenter sélectivement au moins une des composants LEDs 120 de la source. Le circuit électronique implique de préférence au moins un transistor commandé par un signal de commande. De tels circuits ont été proposés pour la technologie d'agencement de sources lumineuses en matrice active. Ils comprennent de préférence en outre une capacité capable de maintenir une charge ou un état de sélection entre deux instants de commande.

La Fig. 2 montre de manière schématique la source lumineuse 100 selon un premier mode de réalisation conforme à l'invention. Une vue d'en bas sur une deuxième face 114 du boîtier 110 de la source lumineuse 110 est montrée. On y aperçoit de manière non-limitative six contacts électriquement conducteurs 140, qui sont reliés à l'intérieur du boîtier, soit aux composants semi-conducteurs électroluminescents 120, soit au circuit électronique 130. Les contacts électriquement conducteurs 140 sont de préférence agencés de manière à connecter le circuit électronique à un potentiel de référence, à un potentiel de masse, et fournir des entrées pour transmettre des signaux de commande pour sélectionner un des trois composants LEDs montrés sur la figure 1. Un sixième contact peut par exemple être relié à un signal de commande supplémentaire. Il va de soi que le nombre de contacts prévus sur la deuxième face inférieure 114 du boitier 110 dépend du nombre de composant LEDs abrités par la source lumineuse 100.

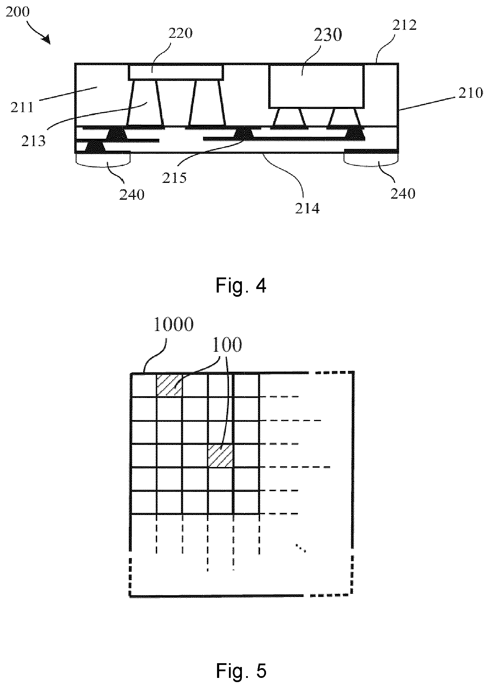

La Fig. 3 montre un autre mode de réalisation d'une source lumineuse 200 selon l'invention. Une vue latérale d'une coupe à travers la source lumineuse est montrée. On y peut apercevoir un des composants semi-conducteurs électroluminescents 220 ainsi qu'un circuit intégré réalisant le circuit électronique 230. La face émettrice des composants LED est généralement à ras de la première face 212 du boîtier 210 de la source lumineuse. Les composants sont noyés dans une résine protectrice en époxy 211 qui donne de la substance au boîtier 210. Des vias 213 permettent de connecter électriquement les composants en question 220, 230 à des couches électriquement conductrices d'interconnexion 215, qui elles sont électriquement reliées à des plots de connexion 240 apparents sur la deuxième face 214 inférieure du boîtier 210. Cette interconnexion entre les plots des LED, circuit intégrés et plots 240 est réalisé par un empilage de couches conductrices 215 ou isolantes 214 que l'on nomme couche de redistribution (RDL, « redistribution layer »).

Selon un autre mode de réalisation, le boîtier de la source lumineuse présente une taille d'arête maximale d'environ 450 micromètres. Le boîtier comprend par exemple et de manière non-limitative trois diodes électroluminescentes. Ceci peut avantageusement comprendre une LED adaptée à émettre de la lumière rouge, une LED adaptée à émettre de la lumière verte et une LED adaptée à émettre de la lumière bleue. Le boîtier comprend également un circuit électronique contenant des transistors de contrôle en CMOS pour chaque LED, afin de permettre leur pilotage selon la technologie de matrice active (« active matrix ») en soi connue. Tous ces composants sont préférablement noyés, mis à part la face émettrice des LEDs, dans une résine de type époxy. Environ six contacts électriques sont prévus sur la face arrière du boîtier, ce qui nécessite que la source lumineuse complète est assemblée sur un PCB de type « fine pitch ». Ce type de substrat est réalisable en utilisant un circuit imprimé organique, un substrat en verre ou en céramique, dont les règles de routage sont compatibles avec l'assemblage.

Le composant est assemblé préférentiellement dans une technologie WLP d'empaquetage au niveau du wafer (« Wafer Level Package »).

Un procédé d'assemblage de type sélection et placement (de type « pick and place » ou bien de « Mass Transfer ») est prévu afin de pouvoir assembler environ 100 mille à 200 mille pixels sur un produit donné. Ceci permet de produire la source lumineuse en accord avec ce mode de réalisation à grande échelle, et à coûts réduits.

Selon encore un autre mode de réalisation, le boîtier de la source lumineuse présente une taille d'arête maximale d'environ 700 micromètres. Le boîtier comprend par exemple et de manière non-limitative quatre pixels espacés d'environ 30 micromètres, pouvant aller jusqu'à 500 micromètres ou plus, dont chaque pixel comporte une LED rouge, une LED verte et une LED bleue. Chaque pixel peut de préférence être conforme au mode de réalisation décrit précédemment. Le boîtier comprend en outre un circuit électronique contenant des transistors CMOS nécessaires pour piloter chaque LED de chaque pixel en mode matrice active. Environ neuf contacts électriques sont réalisés sur la face arrière du boîtier, ce qui nécessite que la source lumineuse est assemblée sur un un substrat de circuit imprimé de type PCB de type « fine pitch » (environ 40 micromètres largeur de piste métal et 40 micromètres d'isolement). Ce type de substrat est réalisable en utilisant un PCB organique, un substrat en verre ou en céramique.

La source lumineuse selon ce mode de réalisation est préférentiellement réalisée en utilisant un substrat de type circuit imprimé, PCB (« printed circuit board »).

L'assemblage de la source lumineuse comprenant une pluralité de pixels peut être réalisé en utilisant un procédé de type sélection et placement (« pick and place » ou bien de « Mass Transfer ») en soi connu dans l'art. 25 à 50 mille composants sont nécessaires pour un dispositif d'affichage typique.

En utilisant les caractéristiques décrites dans le contexte des deux modes de réalisation précédents, par rapport à des procédés de production connus, le nombre de composants à assembler sur le PCB est diminué d'un facteur 3 à 4 (si un pixel RGB est réalisé dans une source lumineuse conforme à un aspect de l'intention), ou d'un facteur 12 à 16 si quatre pixels RGB sont réalisés dans une source lumineuse conforme à un aspect de l'invention.

Pour tous les modes de réalisation de la présente invention, il peut s'avérer avantageux de fournir une couche de passivation minérale ou inorganique sur la première face du boîtier. Elle peut par exemple être en SiO₂ ou en SiOₓNy (oxynitrure de silicium). Une telle couche permet de rendre les micro-LED empaquetées dans la source lumineuse 100, 200 compatible avec l'environnement automobile, qui se caractérise par des conditions hygrométriques, atmosphériques, salines ou autres, adverses. La résine qui entoure les composants au sein du boîtier n'est généralement pas hermétique à long terme. C'est pourquoi la couche proposée peut de préférence être appliquée sur toute la première face 112, 212 du boîtier de la source lumineuse 100, 200, ou au moins sur les faces actives des micro-LEDs 120, 220. Avantageusement, la couche de protection peut être déposée avant l'encapsulation. Ainsi, un sarcophage est constitué, comprenant une enveloppe mince à couches minérales multiples, dont les rôles comprennent ceux de barrière de diffusion et de couche d'accrochage (par le propriétés hydrophile et hydrophobes ainsi générées) pour la résine d'encapsulation et les couches déposées en surface. La ou les couches de protection peuvent être déposées par plasma atmosphérique ou sous vide, pour obtenir de couches d'une épaisseur d'environ 40 nm. A titre d'exemple, trois couches avec des propriétés hydrophiles ou hydrophobes pour créer une barrière hermétique peuvent être appliquées, par exemple : 1 couche d'adhérence (hydrophile), 1 couche d'herméticité (hydrophobe), 1 couche d'adhérence (hydrophile). La faible épaisseur des couches (environ 120nm en agrégé pour l'exemple donné) permet d'éviter l'apparition de contraintes sur les composants qu'elles protègent. Les matériaux employés sont transparents et ne gênent pas la diffusion de la lumière par les micro-LEDs.

Pour tous les modes de réalisation de la présente invention, il peut en plus s'avérer avantageux de fournir un vernis ou une couche de passivation organique sur au moins une partie de la première face 112, 212 du boîtier de la source lumineuse. Ainsi, on peut améliorer la compatibilité des micro-LEDs packagées avec l'environnement automobile en protégeant par exemple la couche de passivation minérale/inorganique contre les chocs/contraintes mécaniques. De plus, la brillance de surface de la résine d'encapsulation et des composants de la source lumineuse 100, 200, par exemple des circuits intégrés au silicium, peut ainsi être réduite. Un vernis mat permet de limiter les effets de brillance et de "ghost" (apparition d'un reflet d'une LED allumée, de sorte que l'utilisateur voit une source allumée là où se trouve une LED éteinte). Le vernis est idéalement noir mais peut avoir une autre couleur. Il peut être appliqué au moins en surface de la micro LED packagée, (par ex : dépôt d'un matériau photosensible pour éliminer le vernis recouvrant les surfaces actives des LED). Le vernis proposé contribue à la performance optique d'un affichage réalisé avec les sources lumineuses proposées et à la fiabilité générale des micro LEDs packagées individuelles.

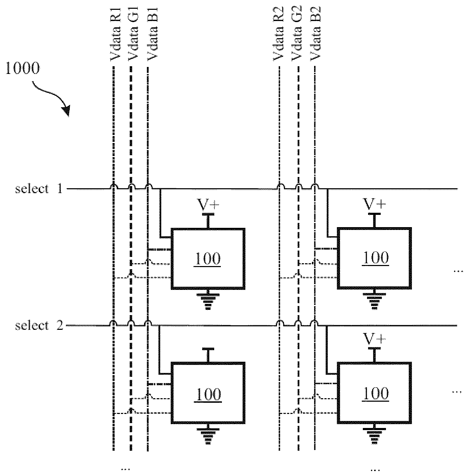

La Fig. 4 montre l'assemblage d'une importante pluralité de sources lumineuse 100 selon un des modes de réalisation qui viennent d'être décrits en une source lumineuse matricielle 1000, chaque source lumineuse 100 réalisant ainsi un pixel qui peut émettre de manière sélective de la lumière de couleur rouge, bleue ou verte. La sélection de chaque pixel est réalisée par un adressage en mode matrice active. La matrice active de transistors nécessaire à cette réalisation est composée des circuit électroniques 130 embarqués dans chacune des sources lumineuses 100. Il suffit de les interconnecter. Il en résulte une grande flexibilité pour la provision de matrices active à micro-LED à dimensions variées. La Figure 5 montre en outre un schéma de montage simplifié d'une telle matrice 1000, permettant de fournir de valeurs de luminosités différentes (Vdata R1, Vdata G1, Vdata B1, respectivement Vdata R2, Vdata G2, Vdata B2) à chaque source élémentaire chaque pixel 100. L'activation du pixel en question se fait par le biais d'un signal de sélection (select 1, respectivement select 2) distinct.

Tous les composants d'une source lumineuse 100, 200, y compris les composants semi-conducteurs électroluminescents et les circuits intégrés abritant les circuits électroniques, sont testables avant leur assemblage, donc seul des composants fonctionnels sont utilisés. Le rendement d'assemblage est d'autant plus élevé que le nombre de pixels qui est intégré dans le boîtier. L'absence de fils est un gain en performance électrique et optique : l'interconnexion est réalisée par des pistes fines en cuivre (line/space minimum 2 micromètres).

Comme le circuit électronique embarqué 130, 230 réalise uniquement une fonction de commande analogique par matrice active, l'espace qu'il occupe au sein du boîtier est très réduit. La configuration d'une pluralité de sources lumineuses selon des aspects de l'invention en matrice active permet d'augmenter la luminance de la source lumineuse par rapport à des sources lumineuses connues dans l'art, pour atteindre 5000 cd/m2, tout en ayant une bonne fiabilité dans un environnement automobile.

Dans ce qui suit, les principales étapes de production d'une source lumineuse selon des aspects de la présente invention seront décrits.

Les composants sont positionnés face active sur un film adhésif avec une précision de +/- 1 micromètre. L'ensemble est encapsulé avec une résine de type époxy de couleur noire. La taille finale sera un wafer ayant un diamètre 8 ou 12 pouces (soit environ 20 à 30.5 cm), ou de diamètre supérieur, ou bien un panneau d'au moins 450x500 mm. La face active est décollée du film et retournée afin d'effectuer l'interconnexion.

La couche d'interconnexion est réalisée par dépôt soustractif ou semi-additif de cuivre. Le nombre de couches conductrices varie de 1 à 4. Un vernis de couleur (noire, blanche, ...) est déposé selon le besoin, afin d'augmenter l'intensité de l'affichage ou d'améliorer le contraste des pixels. L'ensemble des boîtiers est testé et contrôlé comme il est connu de le faire dans l'état de l'art pour un wafer de circuit intégré. L'épaisseur finale est optimisée par polissage de la face arrière. Cette étape est de préférence réalisée après l'encapsulation, afin de définir l'épaisseur du boîtier et d'obtenir une coplanarité acceptable pour le wafer reconstitué. Les boîtiers sont ensuite singulés du wafer ou bien du panneau.

Les composants LEDs sont de préférence préparés avec une couche épaisse de cuivre, de l'ordre de 2 à 3 micromètres ou plus. Il en est de même pour les contacts électriques du circuit intégré réalisant le circuit électrique. Des couches minces sont ensuite déposées par un procédé atmosphérique pour créer une barrière de diffusion. Ces dépôts couche mince de matériaux minéraux précédemment cités vont permettre de réaliser une barrière de diffusion mais également promouvoir une bonne adhésion de la résine. Le tout est alors entouré de résine, dont les résidus superflus sont éliminés. Une couche de passivation diélectrique est alors appliquée et en utilisant un perçage par faisceau Laser, des vias sont ouverts dans la résine pour accéder aux connexions en cuivre de micro-LEDs ainsi que du circuit intégré. Ces vias ou trous sont alors remplis de cuivre par un procédé électrolytique. Une couche de redistribution ou d'interconnexion est appliquée et une nouvelle couche de diélectrique est rajoutée. Ces étapes sont répétées jusqu'à ce que toutes le couches d'interconnexions nécessaires sont réalisées. Le wafer final est testé et décollé du film de protection initial. Comme précédemment décrit, des couches de passivation et/ou un vernis peuvent alors être appliquées à la face supérieure du boîtier ainsi réalisé, avant la singulation des sources du wafer et leur test final.

Il va de soi que les modes de réalisation décrits ne limitent pas l'étendue de la protection de l'invention. En faisant recours à la description qui vient d'être donnée, d'autres modes de réalisation sont envisageables sans pour autant sortir du cadre de la présente invention.

L'étendue de la protection est déterminée par les revendications.

## Revendications

1. Source lumineuse (100, 200) destinée à réaliser au moins un pixel lumineux d'une matrice active (1000) de sources lumineuses, la source lumineuse (100, 200) comprenant un boîtier (110, 210) ayant une première face (112, 212) et une deuxième face (114, 214) y opposée, le boîtier comprenant au moins deux composants semi-conducteurs électroluminescents (120, 220) agencés de manière à pouvoir émettre de la lumière par ladite première face (112, 114), au moins un circuit électronique (130, 230), et des contacts électriquement conducteurs (140, 240) agencés sur la deuxième face (114, 214) et reliés aux composants semi-conducteurs et/ou au circuit électronique, **caractérisée en ce que** le circuit électronique (130, 230) comprend un montage interrupteur adapté à alimenter sélectivement au moins un des composants semi-conducteurs électroluminescents (120, 220).

2. Source lumineuse selon la revendication précédente, **caractérisée en ce que** la face émettrice des composants semi-conducteurs (120, 220) présente une longueur et/ou largeur comprise entre 30 et 70 micromètres.

3. Source lumineuse selon une des revendications précédentes, **caractérisée en ce qu'**elle est destinée à réaliser un pixel lumineux d'une matrice active de sources lumineuses, et **en ce que** la source comprend trois composants semi-conducteurs électroluminescents.

4. Source lumineuse selon la revendication précédente, **caractérisée en ce que** chaque composant semi-conducteur électroluminescent (120, 220) est destiné à émettre de la lumière de couleur différente.

5. Source lumineuse selon une des revendications précédentes, **caractérisée en ce que** la première face (112, 212) du boîtier est au moins partiellement revêtue d'une couche mince de protection.

6. Source lumineuse selon la revendication précédente, **caractérisée en ce que** ladite couche mince de protection comprend au moins une couche inorganique comprenant du Silicium.

7. Source lumineuse selon une des revendications précédentes, **caractérisée en ce que** la première face (112, 212) du boîtier est au moins partiellement revêtue d'une couche de vernis.

8. Source lumineuse selon la revendication précédente, **caractérisée en ce que** ladite couche de vernis comprend une couche de passivation organique, préférentiellement de couleur noire.

9. Dispositif lumineux pixélisé à matrice active (1000) comprenant une pluralité de pixels lumineux, caractérisé en ce les pixels sont réalisés par des sources lumineuses (100, 200) conformes à une des revendications précédentes, les sources lumineuses étant fonctionnellement reliées, et dans lequel les interrupteurs de sélection de la matrice active sont réalisés par les circuits électroniques (130, 230) respectifs des sources lumineuses (100, 200).

10. Module lumineux pour un véhicule automobile, **caractérisé en ce qu'**il comprend au moins un dispositif lumineux conforme à la revendication précédente.

11. Procédé de fabrication d'une source lumineuse, comprenant les étapes suivantes :
- placement, sur une surface de support, d'au moins deux composants semi-conducteurs électroluminescents (120, 220) et d'un circuit intégré (130, 230) réalisant un circuit d'interrupteur adapté à alimenter sélectivement au moins un des composants semi-conducteurs électroluminescents, les faces émettrices des éléments semi-conducteurs électroluminescents étant tournées vers le bas ;
- réalisation d'une encapsulation wafer (« wafer level packaging »), comprenant une étape de moulage d'une résine autour desdits composants (120,130 ; 220,230);
- après la séparation de ladite encapsulation de ladite surface de support, application d'une mince couche de protection comprenant du Silicium sur au moins les faces émettrices des éléments semi-conducteurs.

12. Procédé selon la revendication précédente, comprenant en outre une étape d'application d'un vernis sur au moins les faces émettrices des éléments semi-conducteurs.
